# EUROPEAN PATENT SPECIFICATION

(11) **EP 2 865 729 B1**
(45) Date of publication and mention of the grant of the patent: **09.08.2017**
(21) Application number: 14188322.3
(22) Date of filing: 09.10.2014
(51) Int. Cl.: C09K 5/14, H05K 7/20

(54) **HEAT-DISSIPATING FILM, AND ITS PRODUCTION METHOD**
WÄRMEABLEITENDE FOLIE SOWIE DEREN HERSTELLUNGSVERFAHREN
FILM DE DISSIPATION DE CHALEUR ET SON PROCÉDÉ DE PRODUCTION

(30) Priority: 25.10.2013 JP 2013222128
(43) Date of publication of application: 29.04.2015
(73) Proprietor: Kagawa, Seiji, Saitama 343-0807 (JP)
(72) Inventor: Kagawa, Seiji, Saitama 343-0807 (JP)
(74) Representative: Schwabe - Sandmair - Marx

(56) References cited:
- EP-A1- 3 034 292
- EP-A2- 0 967 423
- US-A1- 2012 219 719
- YANG S Y ET AL: "Synergetic effects of graphene platelets and carbon nanotubes on the mechanical and thermal properties of epoxy composites", CARBON, ELSEVIER, OXFORD, GB, vol. 49, no. 3, 1 March 2011 (2011-03-01), pages 793-803, XP027561956, ISSN: 0008-6223 [retrieved on 2010-12-15]

## Description

### FIELD OF THE INVENTION

The present invention relates to a heat-dissipating film for efficiently dissipating heat generated from electronic parts, etc. in small electronic appliances such as note-type personal computers, smartphones, tablets, mobile phones, etc., and its production method.

### BACKGROUND OF THE INVENTION

In small electronic appliances such as note-type personal computers, smartphones, tablets, mobile phones, etc., which have been provided with increasingly higher performance and more functions, electronic devices such as microprocessors, imaging chips, memories, etc. should be mounted densely. Accordingly, to prevent malfunction due to heat generated by them, the dissipation of heat generated from such electronic devices has become increasingly important.

Heat-dissipating graphite sheets have been conventionally proposed for heat dissipation of electronic parts. For example, JP 2006-306068 A discloses a heat-conductive sheet comprising at least a graphite film and an adhesive resin composition, which is a reaction-curable vinyl polymer. The graphite film is obtained by heat-treating (a) expanded graphite formed by an expanding method, or (b) a polyimide film, etc., at a temperature of 2400°C or higher. The expanded graphite film is obtained by immersing graphite in acid such as sulfuric acid, etc. to form a graphite interlayer compound, heat-treating the graphite interlayer compound to foam it, thereby separating graphite layers, washing the resultant graphite powder to remove acid, and rolling the resultant thin-film graphite powder. However, the expanded graphite film has insufficient film strength. Also, the graphite film obtained by the heat treatment of a polyimide film, etc. is disadvantageously expensive despite high heat dissipation.

JP 2012-211259 A discloses a heat-conductive sheet comprising graphite pieces, which comprise pluralities of first graphite pieces obtained by thinly cutting a thermally decomposed graphite sheet, and second graphite pieces smaller than the widths of the first graphite pieces, at least the first graphite pieces connecting both surfaces of the heat-conductive sheet. This heat-conductive sheet is obtained, for example, by blending a mixture of a acrylic polymer and a solvent with the first and second graphite pieces, and extruding the blend. However, the extruded heat-conductive sheet does not have sufficient heat dissipation, because of a high volume fraction of the resin.

JP 2012-140308 A discloses a method for transferring a graphene film comprising the steps of attaching one or more graphene layers formed on a first substrate (for example, having a nickel catalyst layer formed on a copper substrate) to a second substrate (plastics, etc.) via a resin layer having an adhesive containing less than 1% by weight of a volatile component, and removing the first substrate. However, the graphene layers are formed by CVD, taking an extremely long period of time to achieve sufficient thickness. As a result, the graphene layers must be expensive.

Though a heat-conductive layer of fine graphene particles has good thermal conductivity, it has poor bending rupture resistance (resistance to cracking and breakage when bent). Though elongated carbon nanotube is used as an additive for improving the mechanical strength of a resin, extremely fine carbon nanotube is inevitably agglomerated when its dispersion is applied. Therefore, attempts of forming heat-conductive layers with carbon nanotube have not been succeeded.

EP 0 967 423 A2 discloses a packing yarn and a method of manufacturing a packing yarn composed of two bands which are joined together by a yarn manufacturing method. Moreover, there is disclosed a laminating apparatus comprising a plurality of conveying means, rollers, pressing means, dispersion-applying means, heating/burning means.

EP 3 034 292 A1, which is a document pursuant to Article 54(3) EPC, shows an apparatus for producing a heat-dissipating film, comprising (a) means for conveying a pair of first plastic films; (b) at least one dispersion-applying means disposed for each first plastic film for applying a dispersion comprising flaky carbon and a binder resin to the first plastic film plural times; (c) a means for drying the dispersion after each application; (d) a means for laminating a pair of the first plastic films each having the resultant mixture layer of the flaky carbon and the binder resin, with the mixture layer inside; (e) a means for heat-pressing the resultant laminated film; (f) a means for peeling the first plastic films from the laminated film; (g) a means for burning the mixture layer to carbonize or burn off the binder resin in the exposed mixture layer; (h) a pressing die means for densifying the resultant burnt layer to form a heat-conductive layer; and (i) a means for sealing the heat-conductive layer with the second plastic films.

### OBJECTS OF THE INVENTION

Accordingly, the first object of the present invention is to provide an inexpensive heat-dissipating film exhibiting excellent heat dissipation when disposed in small electronic appliances, and having good bending rupture resistance.

The second object of the present invention is to provide a method for producing such a heat-dissipating film at low cost.

### DISCLOSURE OF THE INVENTION

As a result of intensive research in view of the above object, the inventor has found that by uniformly dispersing fine graphene particles and carbon nanotube in a small amount of a binder resin to form a composite layer, burning the binder resin in the composite layer, and pressing the composite layer to eliminate voids generated by burning the binder resin, a heat-dissipating film having high density and thermal conductivity as well as good bending rupture resistance is obtained. The present invention has been completed based on such finding.

Thus, the heat-dissipating film of the present invention comprises a heat-conductive layer comprising fine graphene particles and carbon nanotube uniformly dispersed,
a mass ratio of the carbon nanotube to the total of the fine graphene particles and the carbon nanotube being 0.05-0.2;
the fine graphene particles being substantially aligned with the heat-conductive layer; and
the heat-conductive layer having a density of 1.9 g/cm³ or more and thermal conductivity of 600 W/mK or more.

The heat-conductive layer preferably has a thickness of 50-250 g/m² (expressed by the total weight of fine graphene particles and carbon nanotube per 1 m²).

The heat-dissipating film preferably has surface resistivity of 20 Ω/square or less. The heat-dissipating film preferably has an electromagnetic wave-shielding ratio (reflectance) of 90% or more.

The heat-conductive layer is preferably covered with a plastic film.

The method of the present invention for producing the above heat-dissipating film comprises the steps of
(1) sandwiching a mixture layer comprising the fine graphene particles and the carbon nanotube at the above mass ratio, and further comprising a binder resin at a mass ratio of 0.01-0.1 to the total amount of the fine graphene particles and the carbon nanotube, with a pair of first plastic films, to form a laminated film;
(2) heat-pressing the laminated film to densify the mixture layer;
(3) burning the mixture layer exposed by peeling the first plastic films;
(4) pressing the burnt layer to provide a densified heat-conductive layer; and
(5) covering the densified heat-conductive layer with second plastic films or an insulating resin.

A step of applying a dispersion comprising 5-25% by mass in total of fine graphene particles and carbon nanotube and 0.05-2.5% by mass of a binder resin in an organic solvent, a mass ratio of the binder resin/(fine graphene particles + carbon nanotube) being 0.01-0.1, to a surface of each first plastic film, and then drying the dispersion is preferably repeated plural times, to form the mixture layer.

The amount of the dispersion applied by one operation is preferably 5-30 g/m² (expressed by the total weight of fine graphene particles and carbon nanotube per 1 m²).

The binder resin is preferably an acrylic resin, a polystyrene resin or polyvinyl alcohol.

The organic solvent is preferably at least one selected from the group consisting of ketones, aromatic hydrocarbons and alcohols.

The dispersion is preferably applied by a spraying method.

The first plastic film preferably has a parting layer on a surface to be coated with the dispersion. The parting layer is preferably a vapor-deposited aluminum layer.

The first plastic film having a vapor-deposited aluminum layer preferably has large numbers of fine penetrating pores, to have air permeability of 50 seconds or less (a time period in which 100 cc of air passes through a cross section having a diameter of 1 inch, measured by a Gurley permeability test method, JIS P 8117).

The drying step is conducted preferably at 30-100°C.

The heat-pressing of the laminated film is conducted preferably by passing the laminated film between at least a pair of heating rolls. The heat-pressing temperature is preferably 150-250°C. The heat-pressing pressure is preferably 20 MPa or more.

The burning of the mixture layer is preferably conducted by applying flame to the mixture layer, or exposing the mixture layer to high temperatures of 500°C or higher in the air, in vacuum or in an inert gas.

The pressing of the burnt layer is preferably conducted in a die constraining at least a pair of opposing sides of the burnt layer.

It is preferable that after the burnt layer is put in a cavity of the lower die part, an upper die part having a projection is pressed to the lower die part, such that the projection enters the cavity, and the combined upper and lower die parts are caused to pass through a pair of pressing rolls plural times, to densify the burnt layer.

The die containing the burnt layer is preferably pressed with vibration.

The second plastic film is preferably thinner than the first plastic film. The heat-conductive layer is preferably heat-sealed by the second plastic films. The heat-sealing second plastic film preferably has a sealant layer on a surface attached to the heat-conductive layer.

The heat-conductive layer is preferably cut to a desired shape, and then sealed by the second plastic films.

The apparatus for producing the above heat-dissipating film comprises
(a) rolls for conveying a pair of first plastic films (12a, 12b);
(b) a chamber (4) comprising nozzles (45a, 45b) for applying a dispersion comprising fine graphene particles, carbon nanotube and a binder resin to each first plastic film (12a, 12b) plural times;
(c) openings (42a, 42b) of said chamber (4) for supplying hot air into said chamber (4) to dry said dispersion in every application;
(d) a pair of rolls (46a, 46b) for laminating a pair of said first plastic films (12a, 12b) each having a mixture layer (11a, 11b) comprising said fine graphene particles, said carbon nanotube and said binder resin, to form a laminated film (1') with said mixture layers (11a, 11b) inside;
(e) at least a pair of heating rolls (47a, 47b, 48a, 48b) for heat-pressing the laminated film (1');
(f) a pair of rolls (101a, 101b) for peeling said first plastic films (12a, 12b) from said laminated film (1') to provide an exposed mixture layer (11);
(g) a burner (114) or a pair of heaters (123a, 123b) for burning the exposed mixture layer (11) to provide a burnt layer (131);
(h) a pressing apparatus (120) for densifying the burnt layer (131) to provide a heat-conductive layer (10); and
(i) a pair of rolls (102a, 102b) for covering said heat-conductive layer (10) with second plastic films (13a, 13b) or an insulating resin.

Said apparatus preferably comprises pluralities of dispersion-applying means arranged with predetermined intervals along the progressing direction of each first plastic film.

A pair of dispersion-applying means and the laminating rolls are preferably disposed in a chamber, which comprises first openings for supplying each first plastic film, a pair of hot-air-supplying openings each disposed near each first opening, an air-discharging opening, and a second opening for withdrawing the laminated film. When plural pairs of dispersion-applying means are disposed, all dispersion-applying means are preferably disposed in the chamber.

The first plastic films are preferably conveyed horizontally on both sides of the laminating rolls by the means (a).

The dispersion-applying means is preferably a spraying nozzle.

Both of the laminating means and the heat-pressing means are preferably heat rolls.

The means for burning the mixture layer is preferably a burner for ejecting flame onto the mixture layer, or a furnace for exposing high temperatures of 500°C or higher to the mixture layer in the air, in vacuum, or in an inert gas.

The pressing means for densifying the burnt layer preferably comprises (a) a die comprising a lower die part having a cavity, and an upper die part having a projection engageable with the cavity; (b) a pair of pressing rolls for pressing the die from above and below; (c) guide plates extending upstream and downstream of the gap of the rolls; and (d) a means for reciprocating the die along the guide plates, such that it passes through a pair of the pressing rolls.

The pressing means preferably comprises a means for applying vibration to one of the pressing rolls, thereby further densifying the burnt layer by vibration pressing.

### BRIEF DESCRIPTION OF THE DRAWINGS

Fig. 1 is a cross-sectional view showing the heat-dissipating film of the present invention.
Fig. 2 is a schematic view showing a method of determining a particle size of a fine graphene particle.
Fig. 3 is a cross-sectional view showing the agglomeration of fine graphene particles when a plastic film is thickly coated with a dispersion comprising fine graphene particles, carbon nanotube and a binder resin.
Fig. 4 is a cross-sectional view schematically showing the uniform dispersion of fine graphene particles and carbon nanotube when a plastic film is thinly coated with the dispersion.
Fig. 5 is a cross-sectional view showing a thin dispersion layer comprising fine graphene particles, carbon nanotube and a binder resin, which is formed on a dried dispersion layer on a plastic film.
Fig. 6 is a cross-sectional view showing an apparatus for producing the heat-dissipating film of the present invention.
Fig. 7 is a plan view showing a line for cutting off edge portions of the mixture layer.
Fig. 8(a) is a schematic cross-sectional view showing an example of methods of burning the mixture layer.
Fig. 8(b) is a schematic cross-sectional view showing another example of methods of burning the mixture layer.
Fig. 9(a) is a plan view showing a lower die part in an apparatus for pressing the burned layer.
Fig. 9(b) is an exploded cross-sectional view showing upper and lower die parts in an apparatus for pressing the burned layer.
Fig. 10 is a cross-sectional view showing the pressing of a burnt layer by a die comprising upper and lower die parts.
Fig. 11(a) is a partial cross-sectional view showing the pressing of the die of Fig. 10 with a pair of pressing rolls.
Fig. 11(b) is a partial cross-sectional view showing the repeated pressing of the die of Fig. 10 with a pair of pressing rolls.
Fig. 12(a) is a plan view showing a die for pressing the burned layer.
Fig. 12(b) is a cross-sectional view showing a die for pressing the burned layer.
Fig. 13 is a plan view showing a cutting line along which edge portions are cut off from a heat-conductive layer obtained by pressing to a predetermined size.
Fig. 14 is a plan view showing cutting lines along which a heat-conductive layer obtained by pressing are divided to final shapes.
Fig. 15 is a cross-sectional view showing a method for laminating a second plastic film having the heat-conductive layer shown in Fig. 13 to another second plastic film.
Fig. 16(a) is a plan view showing a heat-conductive layer of a final shape adhered to the second plastic film.
Fig. 16(b) is a plan view showing a laminated film comprising a second plastic film having heat-conductive layers of a final shape, which is attached to another second plastic film.
Fig. 17 is a cross-sectional view showing a method for laminating a second plastic film having heat-conductive layers of a final shape with another second plastic film.
Fig. 18 is a plan view showing cutting lines along which a laminated film comprising heat-conductive layers of a final shape is cut to individual heat-dissipating films.
Fig. 19 is a cross-sectional view showing a heat-dissipating film comprising a heat-conductive layer sealed by a pair of second plastic films.
Fig. 20 is a graph showing the relation between a mass ratio of carbon nanotube / (fine graphene particles + carbon nanotube) and the in-plane thermal conductivity of the heat-conductive layer.
Fig. 21 is a graph showing the relation between density and in-plane thermal conductivity in the heat-conductive layers.

### DESCRIPTION OF THE PREFERRED EMBODIMENTS

The embodiments of the present invention will be explained in detail below referring to the attached drawings. Explanations of each embodiment are applicable to other embodiments unless otherwise mentioned. Explanations below are not restrictive, but various modifications may be made within the scope of the present invention.

### [1] Heat-dissipating film

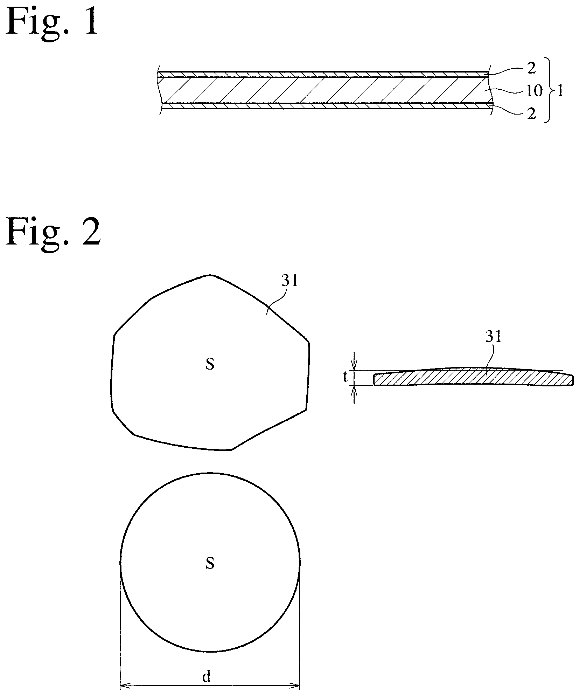

As shown in Fig. 1, a heat-dissipating film 1 according to an embodiment of the present invention comprises a heat-conductive layer 10, and a pair of plastic films 2, 2 adhered to both surfaces of the heat-conductive layer 10 for sealing.

### (1) Heat-conductive layer

The heat-conductive layer 10 comprises fine graphene particles and carbon nanotube. A binder resin contained in the mixture layer, a precursor of the heat-conductive layer 10, is burned out or carbonized. Even though the carbonized binder resin remains, the heat-conductive layer 10 exhibits high thermal conductivity because of increased percentages of fine graphene particles and carbon nanotube due to extreme volume decrease by carbonization.

### (a) Fine graphene particles

A fine graphene particle has a flake- or plate-like, multi-layer structure, in which benzene rings are two-dimensionally connected. Because the fine graphene particle has a lattice structure of benzene rings, each carbon atom is bonded to three carbon atoms, one of four peripheral electrons used for chemical bonding is in a free state (free electron). Because free electrons can move along the crystal lattice, fine graphene particles have high thermal conductivity.

Because a flake-like, fine graphene particle 31 has a planar contour of an irregular shape as shown in Fig. 2, the size (diameter) of each fine graphene particle 31 is defined as a diameter d of a circle having the same area S. Because the size of each fine graphene particle 31 is expressed by a diameter d and a thickness t, the average diameter of fine graphene particles 31 used is expressed by (∑d)/n, wherein n represents the number of fine graphene particles 31 measured, and the average thickness of fine graphene particles 31 is expressed by (∑t)/n. The diameters d and thickness t of fine graphene particles 31 can be determined by the image treatment of photomicrographs of fine graphene particles 31.

The average diameter of flake-like, fine graphene particles may be in a range of 5-100 µm. When the average diameter of fine graphene particles is less than 5 µm, bonded carbon atoms are not sufficiently long, providing the heat-conductive layer 10 with too small thermal conductivity. On the other hand, fine graphene particles having an average diameter of more than 100 µm make spray coating difficult. The average diameter of fine graphene particles is preferably 5-50 µm, more preferably 10-30 µm. The average thickness of fine graphene particles may be in a range of 5-50 nm. When the average thickness of fine graphene particles is less than 5 nm, a binder resin entering gaps between fine graphene particles provides the heat-conductive layer 10 with large resistivity. On the other hand, fine graphene particles having an average thickness of more than 50 nm are easily broken when uniformly dispersed in a solvent. The average thickness of fine graphene particles is preferably 5-30 nm, more preferably 10-25 nm.

### (b) Carbon nanotube

Carbon nanotube is a material constituted by a single- or multi-layer, coaxial tube of a network (graphene sheet) of six-carbon rings (benzene rings), a single-layer one being called single-wall nanotube, and a multi-layer one being called multi-wall nanotube. Both of them can be used in the present invention. Carbon nanotube generally has a diameter of 0.4-50 nm. Carbon nanotube suitable for the present invention is generally as long as one to several tens of micrometers. Elongated carbon nanotube uniformly dispersed in fine graphene particles provides the heat-conductive layer with increased mechanical strength.

A mass ratio of carbon nanotube to (fine graphene particles + carbon nanotube) is 0.05-0.2. The carbon nanotube mass ratio of less than 0.05 fails to provide a layer of fine graphene particles with improved mechanical strength. On the other hand, the carbon nanotube mass ratio of more than 0.2 makes the uniform dispersion of carbon nanotube difficult, resulting in partial agglomeration. The mass ratio of carbon nanotube is preferably 0.075-0.15.

### (c) Binder resin

The binder resin is not particularly restricted, as long as it can be dissolved in an organic solvent to form a uniform dispersion of fine graphene particles and carbon nanotube, and acrylic resins (polymethylacrylate, polymethylmethacrylate, etc.), polystyrenes, polycarbonates, polyvinyl chloride, ABS resins, low-stereospecificity polypropylene, atactic polypropylene, etc. may be used. Among them, polymethylmethacrylate, polystyrenes and low-stereospecificity polypropylene are preferable.

A lower mass ratio of the binder resin/(fine graphene particles + carbon nanotube) provides the heat-conductive layer with higher density and higher thermal conductivity. However, too small a percentage of the binder resin provides insufficient adhesion strength to fine graphene particles and carbon nanotube in the heat-conductive layer, so that the heat-conductive layer is easily broken. To have high thermal conductivity and strength, the mass ratio of the binder resin/(fine graphene particles + carbon nanotube) is preferably 0.01-0.1. The upper limit of the mass ratio of the binder resin/(fine graphene particles + carbon nanotube) is more preferably 0.08, most preferably 0.06. Though the lower limit of the mass ratio of the binder resin/(fine graphene particles + carbon nanotube) is preferably as small as possible, as long as the bonding of fine graphene particles and carbon nanotube is secured, its technological limit is 0.01, practically 0.03.

### (d) Uniform distribution of fine graphene particles and carbon nanotube

If fine graphene particles and carbon nanotube were not uniformly distributed in the mixture layer, (a) fine graphene particles and carbon nanotube would be agglomerated, generating regions with insufficient fine graphene particles and carbon nanotube, and thus failing to provide the heat-dissipating film with the desired thermal conductivity, and (b) the resultant heat-dissipating film would have non-uniform thermal conductivity distribution, providing pieces having insufficient thermal conductivity when divided for individual electronic appliances or parts. To obtain a heat-conductive layer with uniform thermal conductivity distribution, a mixture layer of uniformly distributed fine graphene particles and carbon nanotube should be formed in each application step.

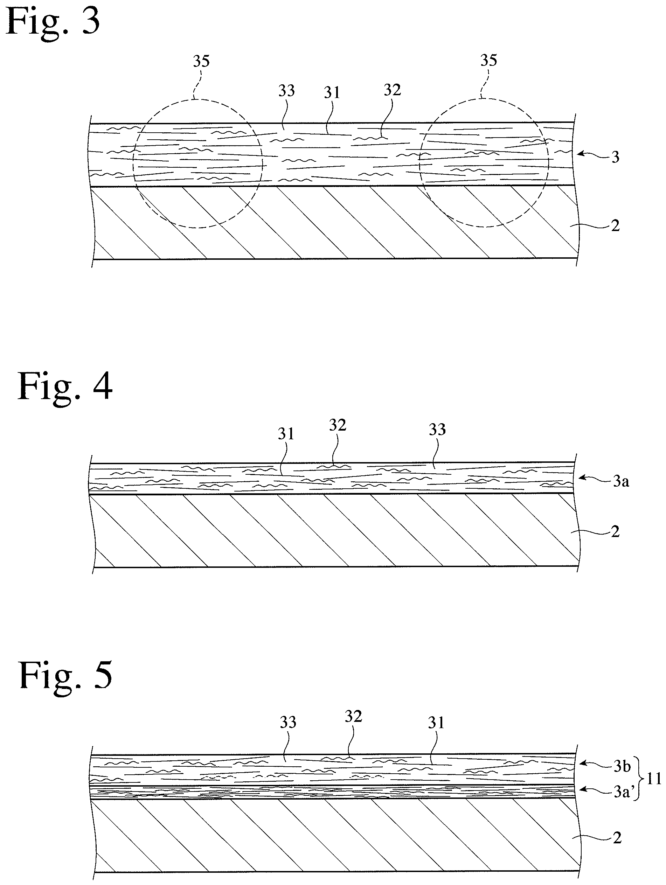

When fine graphene particles 31 and carbon nanotube 32 are agglomerated in the mixture layer, the mixture layer has regions 35 in which fine graphene particles 31 and carbon nanotube 32 are agglomerated, and regions free of or scarcely containing fine graphene particles 31 and carbon nanotube 32 as shown in Fig. 3. The existence of regions free of or scarcely containing fine graphene particles 31 and carbon nanotube 32 provides the heat-conductive layer 10 with low thermal conductivity as a whole. Accordingly, fine graphene particles 31 and carbon nanotube 32 should be dispersed as uniformly as possible.

### (e) Surface resistivity

The heat-dissipating film of the present invention can also function as an electromagnetic wave-shielding film. To exhibit a sufficient electromagnetic wave-shielding function, the surface resistivity of the heat-conductive layer 10 is preferably 20 Ω/square or less, more preferably 10 Ω/square or less. The surface resistivity is measured by a DC two-terminal method on a square specimen of 10 cm x 10 cm cut out of the heat-conductive layer 10.

### (f) Thickness

The thermal conductivity of the heat-conductive layer 10 depends on the thickness of the heat-conductive layer 10. Because what largely contributes to thermal conductivity are fine graphene particles and carbon nanotube in the heat-conductive layer 10, the thickness of the heat-conductive layer 10 is preferably expressed by the total amount of fine graphene particles and carbon nanotube per a unit area. The thickness of the heat-conductive layer 10, which is expressed by the total amount of fine graphene particles and carbon nanotube per a unit area, is preferably 50-250 g/m², more preferably 70-220 g/m², most preferably 80-200 g/m².

### (2) Plastic film

Resins for forming the plastic film are not particularly restricted, as long as they have sufficient strength, flexibility and formability in addition to insulation. They may be, for example, polyesters (polyethylene terephthalate, etc.), polyarylene sulfide (polyphenylene sulfide, etc.), polyether sulfone, polyether ether ketones, polyamides, polyimides, polyolefins (polypropylene, etc.). The thickness of the plastic film may be about 5-20 µm.

### (3) Cutting of heat-dissipating sheet

Because a relatively large heat-dissipating sheet is formed for the purpose of mass production, it may have to be cut to a proper size when attached to small electronic appliances. In such a case, the heat-conductive layer 10 is preferably cut with a cutter having flat portions on both sides of each blade, while fusing a cut portion of the plastic film 2 by heating or ultrasonic waves, to avoid the cut cross section from being exposed. As described below, the heat-conductive layer 10 may be first cut to a predetermined size, laminated with plastic films 2, and then cut in a portion comprising only the plastic films 2.

### [2] Apparatus and method for producing heat-dissipating film

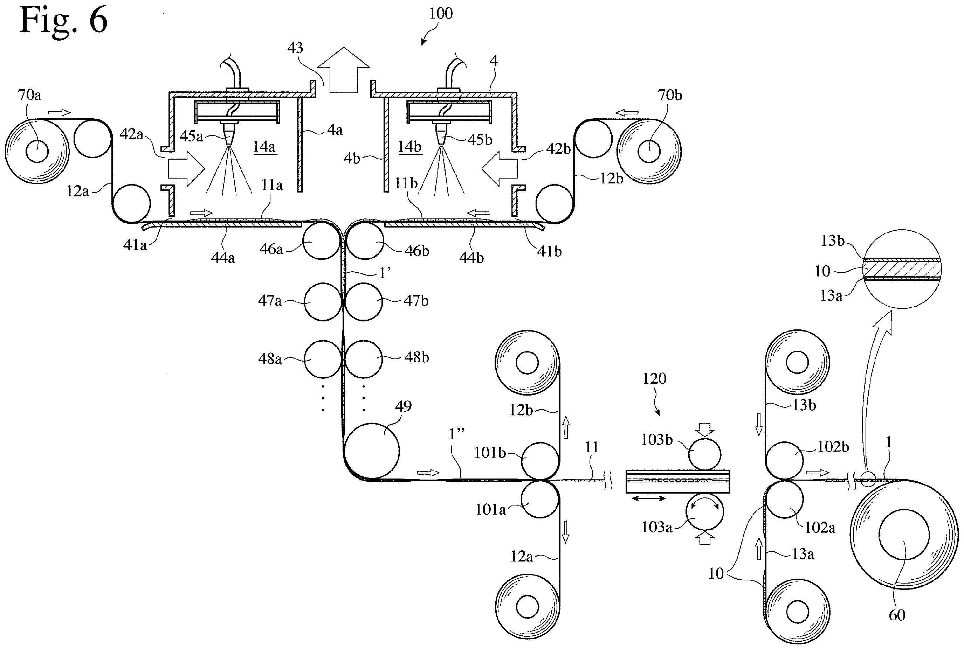

Fig. 6 schematically shows an apparatus 100 for producing the heat-dissipating film. In the depicted example, the apparatus comprises a pair of dispersion-applying means laterally. The apparatus 100 comprises (a) a chamber 4 comprising openings 41a, 41b through which first plastic films 12a, 12b are supplied, hot-air-supplying openings 42a, 42b, and an air-discharging opening 43; (b) a pair of nozzles 45a, 45b mounted to a ceiling of the chamber 4 for spraying a dispersion comprising fine graphene particles, carbon nanotube and a binder resin, to form a mixture layer 11a, 11b on each first plastic film 12a, 12b; (c) a pair of rolls 46a, 46b for laminating the first plastic films 12a, 12b each having a mixture layer 11a, 11b, with the mixture layers 11a, 11b inside; (d) at least a pair of heating rolls for heat-pressing the laminated film 1' (two pairs of heating rolls 47a, 47b, 48a, 48b in the depicted example); (e) a guide roll 49 for conveying the laminated film 1'; (f) a pair of rolls 101a, 101b for peeling the first plastic films 12a, 12b from the laminated film 1'; (g) a means (not shown) for burning the exposed mixture layer 11; (h) a means 120 for pressing the burnt layer 110; (i) a pair of rolls 102a, 102b for covering (sealing) the resultant heat-conductive layer 10 with a pair of second plastic films 13a, 13b; and (j) a reel 60 for winding the resultant heat-dissipating film 1. The first plastic films 12a, 12b fed out of the reels 70a, 70b are supplied to the lateral openings 41a, 41b of the chamber 4 via pluralities of guide rolls.

The first plastic films 12a, 12b should have sufficient mechanical strength and heat resistance to withstand a laminating step and a heat-pressing step. Accordingly, the first plastic films 12a, 12b are preferably relatively thick films of a heat-resistance resin. The heat-resistance resin is preferably polyethylene terephthalate, polyimide, etc. The first plastic films 12a, 12b are preferably as thick as 10-50 µm. The first plastic film 12 may be reusable after peeling.

Each first plastic film 12a, 12b is preferably provided with a parting layer in advance, on a surface to be coated with the dispersion. The parting layer is preferably a vapor-deposited aluminum layer. To accelerate the vaporization of an organic solvent from the dispersion, each first plastic film 12a, 12b having a vapor-deposited aluminum layer is preferably provided with large numbers of fine penetrating pores in advance. The penetrating pores preferably have an average diameter of about 5-20 µm, and the number of penetrating pores is determined to obtain air permeability of 50 seconds or less (measured by a Gurley permeability test method, JIS P 8117). Such penetrating pores can be formed by pressing with a diamond roll.

However, as low-thermal-conductivity plastic films covering both surfaces of the heat-conductive layer 10 become thicker, the thermal conductivity of the heat-dissipating sheet 1 becomes lower. Accordingly, the plastic films covering both surfaces of the heat-conductive layer 10 should be as thin as possible. As described above, the second plastic films 13a, 13b are preferably as thick as 5-15 µm. Each second plastic film 13a, 13b preferably has a sealant layer, such that it is strongly fused to the heat-conductive layer 10 by a heat lamination method, etc. Materials for the second plastic films 13a, 13b may be the same as those for the first plastic films 12a, 12b, and an extremely thin polyethylene terephthalate film, which is commercially available, is preferably used in practice.

The chamber 4 comprises a pair of opened vertical walls 4a, 4b on both lateral sides of the air-discharging opening 43, and regions partitioned by the opened vertical walls 4a, 4b are dispersion-coating regions 14a, 14b comprising nozzles 45a, 45b. Horizontal plates 44a, 44b for supporting the first plastic films 12a, 12b are disposed on both lateral sides of the laminating rolls 46a, 46b, and each first plastic film 12a, 12b horizontally moves on each horizontal plate 44a, 44b.

### (1) Preparation of dispersion comprising fine graphene particles, carbon nanotube and binder resin

The dispersion of fine graphene particles, carbon nanotube and a binder resin in an organic solvent is preferably prepared by mixing a dispersion of fine graphene particles and carbon nanotube in an organic solvent with a solution of a binder resin in an organic solvent. This is because fine graphene particles and carbon nanotube would be agglomerated, if fine graphene particles, carbon nanotube and a binder resin were simultaneously mixed in an organic solvent. In a dispersion comprising fine graphene particles, carbon nanotube and a binder resin, which is obtained by mixing both solutions, the concentration of fine graphene particles is preferably 1-10% by mass, more preferably 2-7% by mass, and the concentration of carbon nanotube is preferably 0.06-2.5% by mass, more preferably 0.1-1% by mass, with a mass ratio of the binder resin/(fine graphene particles + carbon nanotube) being 0.01-0.1. The mass ratio of carbon nanotube/(fine graphene particles + carbon nanotube) and the mass ratio of the binder resin/(fine graphene particles + carbon nanotube) are kept without change in the mixture layer.

Organic solvents used for the dispersion are preferably volatile organic solvents, for the purpose of well dispersing fine graphene particles and carbon nanotube, well dissolving the binder resin, and achieving a short drying time. Examples of such organic solvents include ketones such as methyl ethyl ketone, aliphatic hydrocarbons such as hexane, aromatic hydrocarbons such as xylene, and alcohols such as isopropyl alcohol. Among them, methyl ethyl ketone, xylene and isopropyl alcohol are preferable. They may be used alone or in combination.

### (2) Coating and drying of dispersion

When a dispersion of a desired concentration is applied to a plastic film by one operation, it has been found as schematically shown in Fig. 3 that fine graphene particles 31 and carbon nanotube 32 in the dispersion 3 are agglomerated in the course of drying. In Fig. 3, 35 represents regions in which fine graphene particles 31 and carbon nanotube 32 are agglomerated, and 33 represents an organic solvent. Intensive research has revealed that the agglomeration of fine graphene particles 31 and carbon nanotube 32 can be prevented by applying a small amount of the dispersion 3 plural times. Because a small amount of the dispersion is applied in the first step shown in Fig. 4, the resultant dispersion layer 3a is sufficiently thin relative to fine graphene particles 31 and carbon nanotube 32, so that fine graphene particles 31 and carbon nanotube 32 keep their dispersion without agglomeration when the dispersion layer 3a is dried. Accordingly, in the mixture layer 3a' obtained by drying the dispersion layer 3 a, fine graphene particles 31 and carbon nanotube 32 bonded with an extremely small amount of the binder resin are substantially uniformly distributed.

The amount of the dispersion applied by one operation is preferably 5-30 g/m², more preferably 7-20 g/m², as the total weight of fine graphene particles and carbon nanotube per a unit area. When the amount of the dispersion applied is less than 5 g/m², it takes too much time to form the mixture layer. When it is more than 30 g/m², fine graphene particles and carbon nanotube are likely agglomerated. To apply such a small amount of the dispersion uniformly, a spraying method is preferable.

After the dispersion layer 3a is dried, the next application step is conducted. Though the dispersion layer 3a may be spontaneously dried, it may be heated to such an extent as not to deform the plastic film, to finish the application step in a short period of time. The heating temperature is determined depending on the boiling point of an organic solvent used. For example, when methyl ethyl ketone is used, the heating temperature is preferably 30-100°C, more preferably 50-80°C. Drying need not be conducted to completely evaporate an organic solvent from the dispersion layer 3a, but may be conducted to such an extent that fine graphene particles and carbon nanotube are not freed out of the dried layer in the next application step.

When the second application of a dispersion is conducted on the dried first mixture layer 3a', as schematically shown in Fig. 5, a new dispersion layer 3b is formed without substantially dissolving the first mixture layer 3a'. When the dispersion layer 3b is dried, it becomes a second mixture layer integral with the first mixture layer 3a'. The repetition of such cycle of applying and drying a dispersion plural times provides a relatively thick, integral mixture layer, in which fine graphene particles are aligned in parallel, and carbon nanotube is uniformly dispersed. The number of cycles of applying and drying a dispersion is determined depending on the thickness of a mixture layer to be formed.

To conduct the step of applying and drying the above dispersion by the apparatus 100 shown in Fig. 6, each first plastic film 12a, 12b fed out of the reels 70a, 70b is first stopped in the chamber 4. In this state, the dispersion is uniformly sprayed from each nozzle 45a, 45b onto a portion of each first plastic film 12a, 12b in each dispersion-applying region 14a, 14b. To apply the dispersion uniformly, each nozzle 45a, 45b is movable freely. A dispersion layer formed on each first plastic film 12a, 12b is dried by hot air. This step of applying and drying the dispersion is repeated plural times to form a mixture layer 11a, 11b of a predetermined thickness on each first plastic film 12a, 12b.

### (3) Laminating and heat-pressing of mixture layer

The first plastic films 12a, 12b provided with the mixture layers 11a, 11b are laminated by a pair of rolls 46a, 46b, with the mixture layers 11a, 11b inside, to bond the mixture layers 11a, 11b to an integral mixture layer 11.

To completely fuse the mixture layers 11a, 11b by lamination, the laminating rolls 46a, 46b are preferably heated at high temperatures. Though variable depending on the type of the binder resin, the temperature of the laminating rolls 46a, 46b is preferably 100-250°C, more preferably 150-200°C. Pressure by the laminating rolls 46a, 46b need not be large, but may be, for example, 1-10 MPa.

The step of applying and drying the dispersion is then repeated plural times on a new portion of each first plastic film 12a, 12b intermittently reaching the dispersion-applying region 14a, 14b, thereby forming a mixture layer 11a, 11b of predetermined thickness. After the step of applying and drying the dispersion is repeated plural times, each first plastic film 12a, 12b is fed intermittently to form a laminated film 1' having a mixture layer 11 between a pair of first plastic films 12a, 12b.

As shown in Figs. 4 and 5, because fine graphene particles 31 and carbon nanotube 32 are substantially uniformly dispersed in the dispersion layer 3a, only an organic solvent between fine graphene particles 31 and carbon nanotube 32 is evaporated by drying the dispersion layer 3a, leaving voids between fine graphene particles 31 and carbon nanotube 32 bonded with an extremely small amount of the binder resin. Because porous mixture layers 11a, 11b are obtained by laminating pluralities of the mixture layers 3 a' with voids between fine graphene particles 31 and carbon nanotube 32, a dense mixture layer 11 cannot be obtained simply by laminating the first plastic films 12a, 12b having mixture layers 11a, 11b.

Accordingly, a laminated film 1' obtained by passing between the laminating rolls 46a, 46b should be heat-pressed by plural pairs of heat-pressing rolls 47a, 47b, 48a, 48b arranged downstream of the rolls 46a, 46b. Though variable depending on the type of the binder resin, the heat-pressing conditions are preferably a temperature of 100-250°C and pressure of 20 MPa (about 200 kgf/cm²) or more. When the heat-pressing temperature is lower than 100°C, the resultant heat-conductive layer 10 does not have a sufficient density. On the other hand, even if the heat-pressing temperature were higher than 250°C, the effect of fluidizing the binder resin would be saturated, resulting in economic disadvantages. The heat-pressing temperature is preferably 120-200°C, more preferably 150-180°C. When the heat-pressing pressure is less than 20 MPa, the resultant mixture layer 11 does not have a sufficient density.

Though the heat-pressing rolls 47a, 47b, 48a, 48b may be arranged in a single- or multi-stage, their multi-stage arrangement is preferable to produce a laminated film 1' comprising a sufficiently dense mixture layer 11. The number of stages of the heat-pressing rolls 47a, 47b, 48a, 48b may be properly determined depending on a compression rate.

### (4) Burning of mixture layer

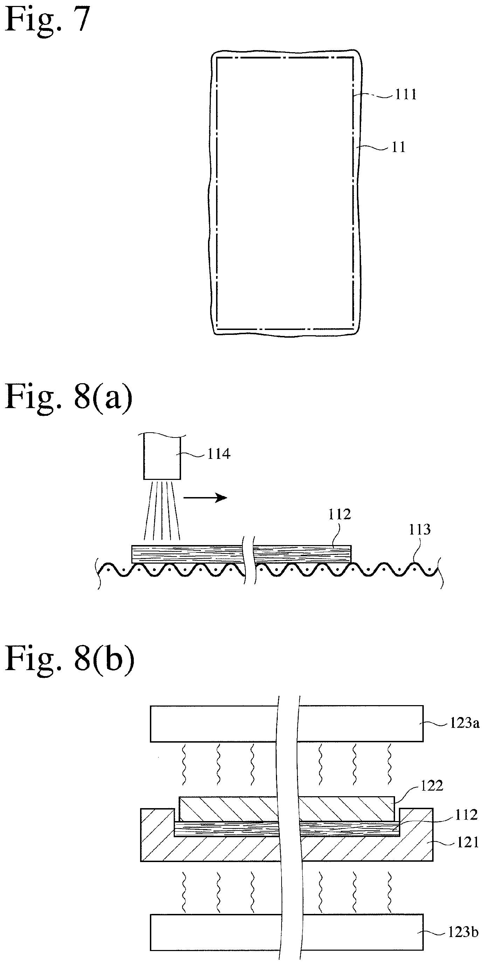

Because the heat-pressed mixture layer 11 has slightly rugged or irregular edge portions due to the flowing of the binder resin, it may be cut to a predetermined shape and size along the broken line 111 before burning, for example, as shown in Fig. 7. The burning of the mixture layer 11 is preferably conducted by (a) ejecting flame onto the mixture layer 11, or by (b) exposing the mixture layer 11 to high temperatures of 500°C or higher in the air, in vacuum, or in an inert gas.

When burned by flame, for example, as shown in Fig. 8(a), the cut mixture layer 112 is placed on a wire net 113, and burned by flame at about 900-1200°C ejected from a burner 114. One surface of the mixture layer 112 may be burned, but it is preferable to burn both surfaces of the mixture layer 112. The binder resin is burned out in the mixture layer 112 exposed to flame ejected from the burner 114. To prevent excessive burning of fine graphene particles and carbon nanotube, the flame-ejecting time is preferably as short as several seconds.

Fig. 8(b) shows another method of burning the mixture layer 112. This method uses a die comprising a lower die part 121 having a cavity and an upper die part 122 slightly larger than the cavity. After the mixture layer 112 is put in the lower die part 121, the upper die part 122 is placed on the mixture layer 112, and sandwiched by a pair of heaters 123a, 123b to heat the mixture layer 112. The temperature of the heaters 123a, 123b may be about 500-1000°C, and the heating time is determined to avoid excessive carbonization of the binder resin. Because the mixture layer 112 is not substantially brought into contact with air during the heat treatment in this method, fine graphene particles and carbon nanotube are prevented from burning.

When the mixture layer is exposed to high temperatures of 500°C or higher in the air, the heating temperature is preferably 500-700°C, more preferably 500-650°C, to prevent excessive burning of fine graphene particles and carbon nanotube. The binder resin is burned out or carbonized by the burning of the mixture layer. Because of volume decrease by the burning or carbonization of the binder resin, pressing to eliminate voids makes fine graphene particles and carbon nanotube much denser, thereby obtaining a heat-conductive layer 10 with high thermal conductivity.

When exposed to high temperatures of 500°C or higher in vacuum or in an inert gas, pluralities of the mixture layers formed are preferably placed in an electric furnace with a vacuum or inert-gas atmosphere, etc., and exposed to high temperatures of 500°C or higher. This method is advantageous not only in preventing the burning of fine graphene particles and carbon nanotube, but also in treating large numbers of mixture layers simultaneously. Because the atmosphere does not contain oxygen, the upper limit of the heating temperature may be about 1000°C. The binder resin exposed to high temperatures in vacuum or in an inert gas is carbonized without burning. As described above, the binder resin is burned or carbonized depending on the method used for the burning treatment of the mixture layer. In both cases, such treatment is called simply "burning" herein.

### (5) Pressing of burnt layer

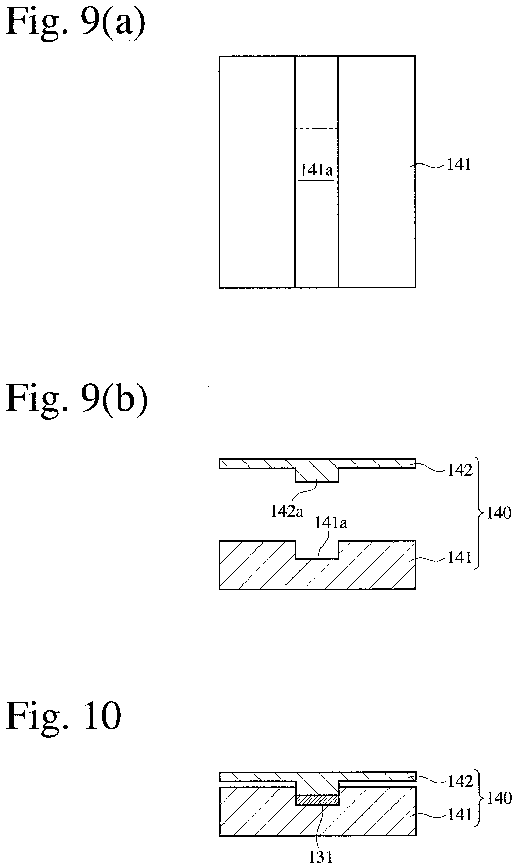

To densify the burnt layer 131 obtained by burning the mixture layer 112, a die 140 comprising a lower die part 141 having a cavity 141a, and an upper die part 142 having a projection 142a received in the cavity 141a is used as shown in Figs. 9(a) and 9(b). In the depicted example, the cavity 141a longitudinally extends from one side to the other in the lower die part 141, with the same width as that of the burnt layer 131. As shown in Fig. 10, after the burnt layer 131 is received in the cavity 141a, the upper die part 142 is placed on the lower die part 141, such that the projection 142a covers the burnt layer 131. In this case, because the thickness of the burnt layer 131 is sufficiently smaller than the depth of the cavity 141a, the projection 142a of the upper die part 142 enters the cavity 141a, thereby accurately positioning the upper die part 142 relative to the lower die part 141.

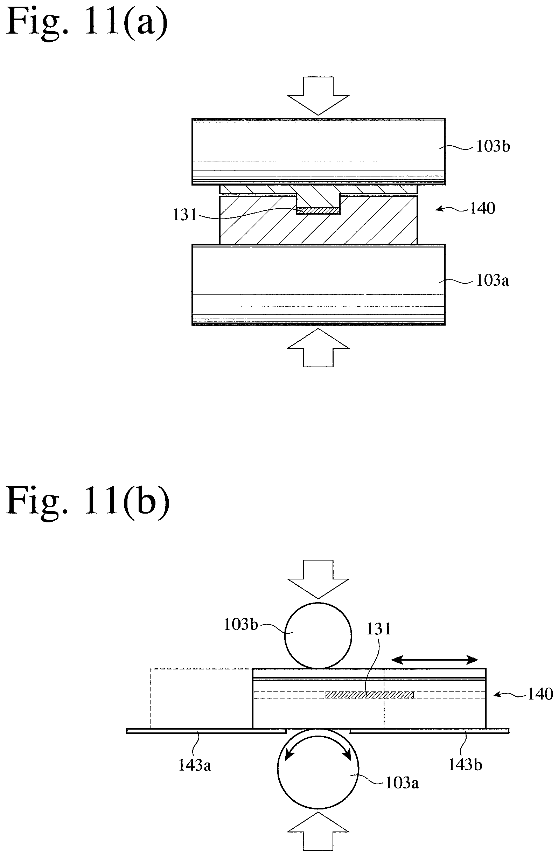

As shown in Figs. 10, 11(a) and 11(b), a pressing means for densifying the burnt layer 131 comprises (a) a die 140 comprising a lower die part 141 and an upper die part 142 combined to sandwich the burnt layer 131, (b) a pair of rolls 103a, 103b for pressing the die 140, (c) guide plates 143a, 143b positioned upstream and downstream of the gap of the rolls 103a, 103b, and (d) a means (not shown) for reciprocating the die 140 along the guide plates 143a, 143b such that the die 140 passes through the gap of a pair of pressing rolls 103a, 103b.

Among a pair of pressing rolls 103a, 103b, the lower pressing roll 103a is a driving roll, and the upper pressing roll 103b is a follower roll. With the follower roll 103b having a slightly smaller diameter than that of the driving roll 103a, the upper die part 142 is free from being curved by pressing. A reciprocation range of the die 140 is sufficiently longer than the burnt layer 131. Reciprocation may be conducted once or several times. A pressing force applied to the die 140 may be increased as passing through the gap of the pressing rolls 103a, 103b. The burnt layer 131 is turned to a heat-conductive layer 10 by pressing the die 140.

With the lower pressing roll 103a vibrated by a vibration motor (not shown), the burnt layer 131 is further densified. The vibration frequency is preferably 50-500 Hz, more preferably 100-300 Hz.

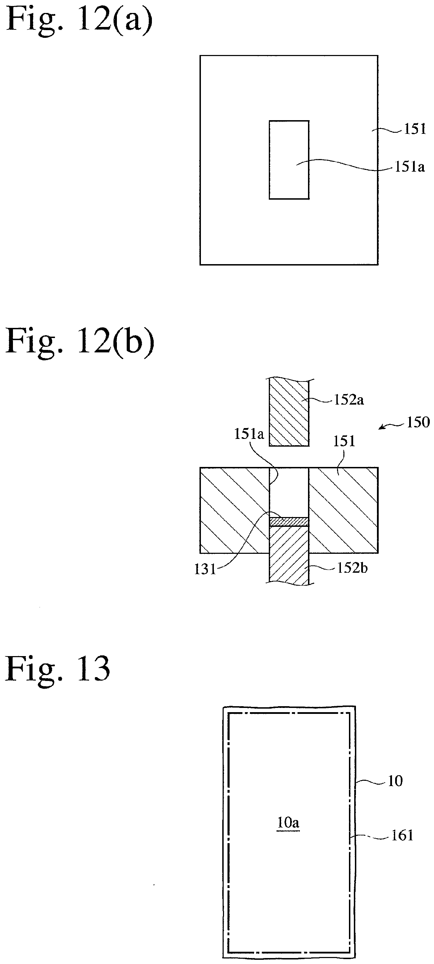

Figs. 12(a) and 12(b) show another example of dies used in the pressing means for densifying the burnt layer. This die 150 comprises a die body 151 having a vertically penetrating cavity 151a, an upper punch 152a inserted into the cavity 151a from above, and a lower punch 152b inserted into the cavity 151a from below. After the lower punch 152b is inserted into the cavity 151 a, a burnt layer 131 is put on the lower punch 152b, and the upper punch 152a inserted into cavity 151a from above is moved downward to press the burnt layer 131 for densification. With the same vibration as above applied to the upper punch 152a, a larger pressing effect is obtained.

### (6) Sealing of heat-conductive layer

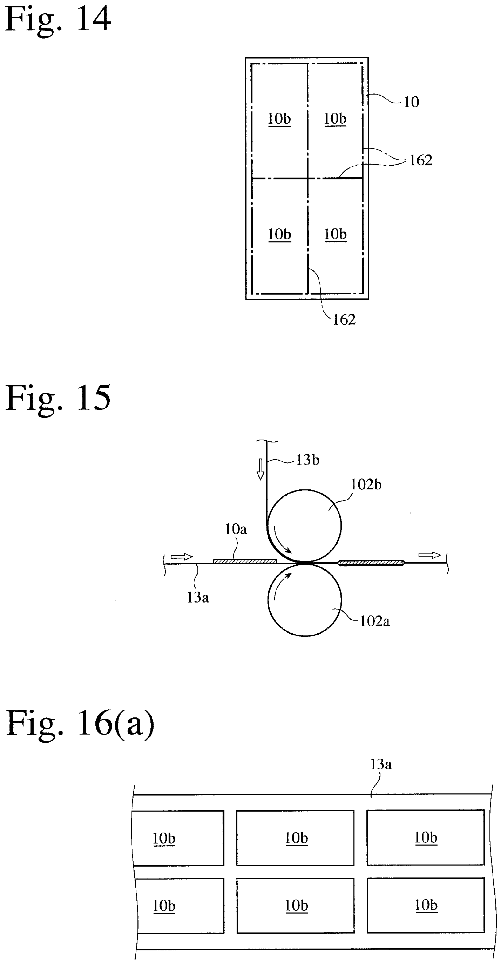

Because the pressed heat-conductive layer 10 has slight irregularity in edge portions, (1) the edge portions are cut off from the heat-conductive layer 10 along the broken line 161 to obtain a heat-conductive layer 10a of a predetermined size as shown in Fig. 13, or (2) the heat-conductive layer 10 is divided along the broken lines 162 to heat-conductive layers 10b of a final size as shown in Fig. 14. In the case shown in Fig. 14, the size, shape and number of the heat-conductive layers 10b may be arbitrarily determined.

In the case of a large heat-conductive layer 10a as shown in Fig. 13, a second plastic film 13a to which the heat-conductive layers 10a are attached with predetermined intervals is laminated with another second plastic film 13b by a pair of rolls 102a, 102b, and the laminated film is cut in every heat-conductive layer 10a to obtain individual heat-dissipating films, as shown in Fig. 15. With the second plastic film 13a having an adhesive layer, the attached heat-conductive layers 10a are not displaced. The second plastic films 13a, 13b are preferably heat-laminated via the heat-conductive layers 10a.

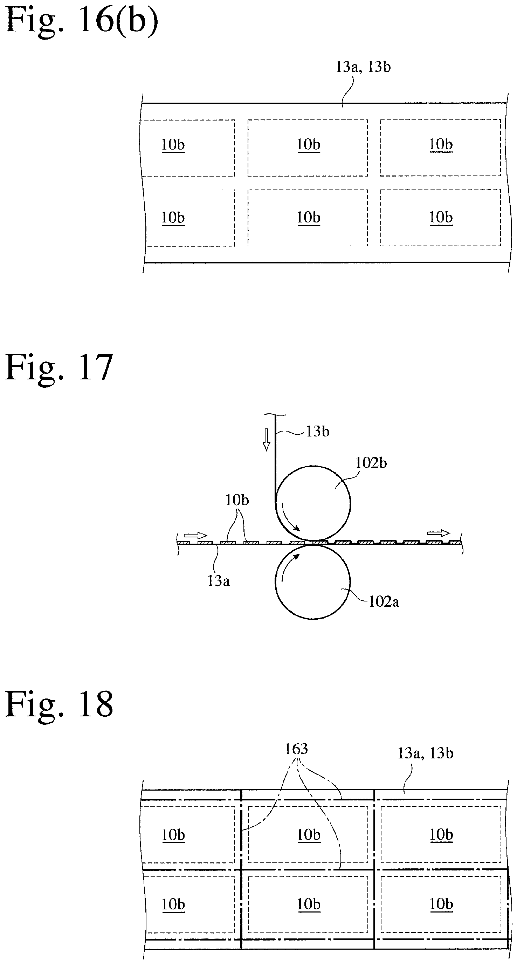

When cut to heat-conductive layers 10b of a final size as shown in Fig. 14, one second plastic film 13a, to which pluralities of heat-conductive layers 10b are attached with predetermined intervals as shown in Fig. 16(a), is first laminated with another second plastic film 13b by a pair of rolls 102a, 102b as shown in Fig. 17, to obtain a laminated film shown in Fig. 18. As shown in Fig. 18, the laminated film is divided along the broken lines 163 to obtain individual heat-dissipating films.

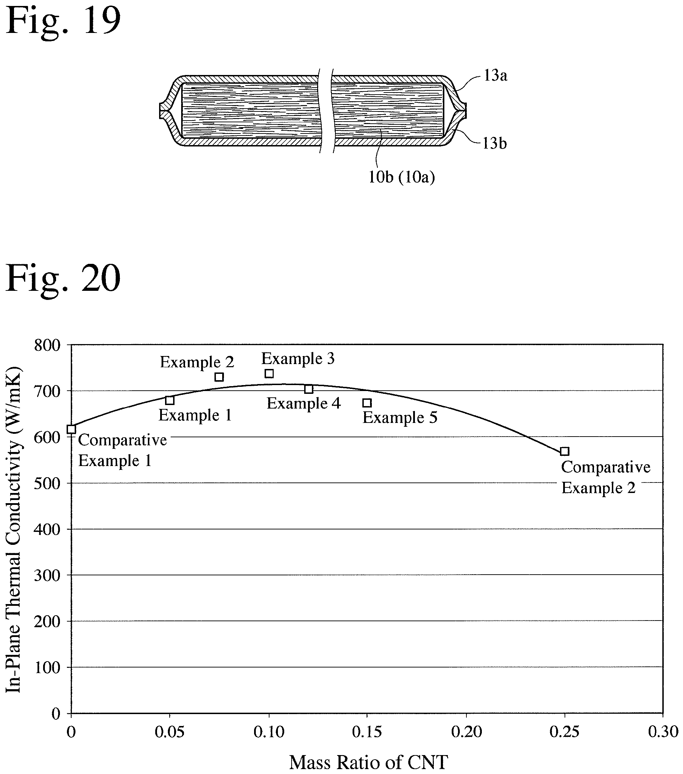

As shown in Fig. 19, each heat-conductive layer 10a (10b) is sandwiched by a pair of second plastic films 13a, 13b, whose edge portions are heat-sealed.

The present invention will be explained in more detail with Examples below without intention of restricting the present invention thereto.

### Examples 1-5, and Comparative Examples 1 and 2

A dispersion comprising flake-like, fine graphene particles (H-25 available from XG Sciences, average diameter: 25 µm, and average thickness: about 15 nm), carbon nanotube (CNT, average diameter: 10-50 nm, and average length: about 25 µm), and polymethylmethacrylate (PMMA) in the proportion shown in Table 1 in an organic solvent (mixed solvent of xylene and isopropyl alcohol at a mass ratio of 6/4) was applied to aluminum-deposited surfaces of two aluminum-deposited polyethylene terephthalate (PET) films (first plastic films) 12a, 12b as thick as 30 µm, and dried at 40°C for 2 minutes to obtain each coating layer of fine graphene particles, carbon nanotube and PMMA having a thickness of 20 g/m² (expressed by the grams of fine graphene particles + carbon nanotube per 1 m²). This procedure was repeated 5 times in total to form a mixture layer 11a, 11b of fine graphene particles, carbon nanotube and PMMA (thickness: 100 g/m²) on each PET film 12a, 12b. Incidentally, the above aluminum-deposited PET films were provided with penetrating pores by a diamond roll, such that it had air permeability of 50 seconds or less (measured by a Gurley permeability test method, JIS P 8117).

**Table 1**

| No. | Composition of Dispersion (% by mass) | | | | |
|---|---|---|---|---|---|
| | Graphene ⁽¹⁾ | CNT ⁽²⁾ | CNT/(Graphene + CNT) | Binder Resin ⁽³⁾ | Solvent ⁽⁴⁾ |
| Com. Ex. 1 | 6.0 | 0 | 0 | 0.6 | 93.4 |
| Example 1 | 5.70 | 0.30 | 0.05 | 0.6 | 93.4 |
| Example 2 | 5.55 | 0.45 | 0.075 | 0.6 | 93.4 |
| Example 3 | 5.40 | 0.60 | 0.10 | 0.6 | 93.4 |
| Example 4 | 5.28 | 0.72 | 0.12 | 0.6 | 93.4 |
| Example 5 | 5.10 | 0.90 | 0.15 | 0.6 | 93.4 |
| Com. Ex. 2 | 4.50 | 1.50 | 0.25 | 0.6 | 93.4 |

| | | | | | |
|---|---|---|---|---|---|
| Note: (1) Fine graphene particles H-25. (2) Carbon nanotube. (3) Polymethylmethacrylate (PMMA). (4) A mixed solvent of xylene and isopropyl alcohol (mass ratio of xylene/isopropyl alcohol = 6/4). | | | | | |

As shown in Fig. 6, a pair of PET films 12a, 12b each having a mixture layer 11a, 11b were laminated at 120°C by a pair of rolls 46a, 46b, with the mixture layers 11a, 11b inside, and then heat-pressed at 150°C by plural pairs of heating rolls 47a, 47b, 48a, 48b under pressure of 20 MPa, to form a laminated film 1' comprising the mixture layer 11.

After peeling both PET films 12a, 12b from the laminated film 1', the mixture layer 11 was kept at 650°C for 30 minutes in air in a furnace, to burn the mixture layer 11. The burnt layer was placed in a cavity 141a of the die 140 shown in Fig. 9, and repeatedly pressed by a pair of rolls 103a, 103b under a load of 6 ton with vibration of 200 Hz, as shown in Figs. 11(a) and 11(b).

After the resultant heat-conductive layer 10 was cut to a predetermined size, its density, specific heat, and heat diffusivity (m²/s) in in-plane and thickness directions were measured. The thermal conductivity (W/mK) was determined from the product of heat diffusivity and heat capacity (density x specific heat). The density, and heat diffusivity and thermal conductivity in in-plane and thickness directions of the heat-conductive layers 10 are shown in Table 2. The relation between the mass ratio of carbon nanotube/(fine graphene particles + carbon nanotube) and the in-plane thermal conductivity of the heat-conductive layer is shown in Fig. 20.

**Table 2**

| No. | Density (g/cm³) | Specific Heat (W·s/kg·K) | Thermal Diffusivity (x 10⁻⁶ m²/s) | | Thermal Conductivity (W/mK) | |
|---|---|---|---|---|---|---|
| | | | In-Plane Direction | Thickness Direction | In-Plane Direction | Thickness Direction |
| Com. Ex. 1 | 2.05 | 880 | 3.41 | 2.52 | 615.5 | 4.55 |
| Example 1 | 2.10 | 880 | 3.67 | 1.99 | 678.0 | 3.68 |
| Example 2 | 2.10 | 880 | 3.94 | 2.23 | 728.1 | 4.12 |
| Example 3 | 2.08 | 880 | 4.03 | 1.74 | 736.6 | 3.19 |
| Example 4 | 2.06 | 880 | 3.87 | 2.03 | 702.3 | 3.68 |
| Example 5 | 2.06 | 880 | 3.72 | 2.34 | 672.8 | 4.24 |
| Com. Ex. 2 | 2.03 | 880 | 3.18 | 2.29 | 568.3 | 4.10 |

As is clear from Tables 1 and 2 and Fig. 20, the heat-conductive layers of Examples 1-5, in which the mass ratio of carbon nanotube/(fine graphene particles + carbon nanotube) was in a range of 0.05-0.2, were remarkably higher in thermal conductivity than the heat-conductive layer of Comparative Example 1 containing no carbon nanotube and the heat-conductive layer of Comparative Example 2 containing excessive carbon nanotube. Particularly low thermal conductivity of the heat-conductive layer of Comparative Example 2 appears to be due to the fact that excessive carbon nanotube was agglomerated.

In a bending test of 90°, the heat-conductive layers of Examples 1-5 were neither cracked nor broken. This indicates that the heat-conductive layers of Examples 1-5 had sufficient bending rupture resistance. On the other hand, the heat-conductive layers of Comparative Examples 1 and 2 were broken by the bending test of 90°. This is due to the fact that the heat-conductive layer of Comparative Example 1 did not contain carbon nanotube, and that the heat-conductive layer of Comparative Example 2 contained excessive carbon nanotube, which was agglomerated.

As shown in Fig. 15, one PET film 13a, to which a heat-conductive layer 10a was attached, was laminated with another PET film 13b by a pair of rolls 102a, 102b. The laminated film 1' was cut to individual heat-dissipating films.

### Example 6

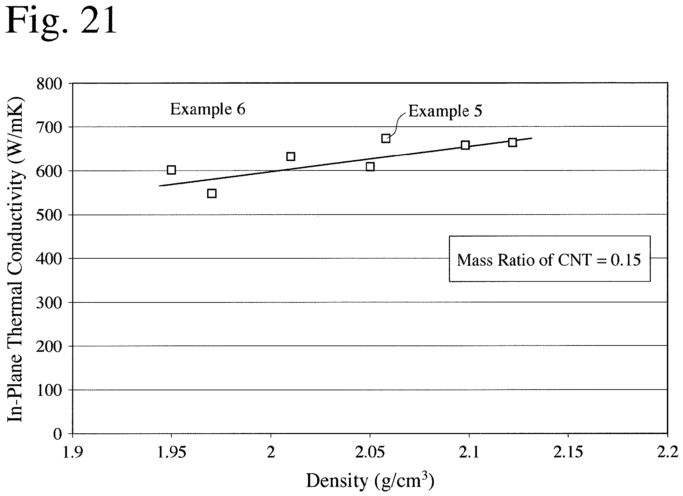

Heat-conductive layers having different densities were produced by changing the pressing pressure of the burnt layer having the same composition as in Example 5. The relation between the density and in-plane thermal conductivity of the heat-conductive layer is shown in Fig. 21. It is clear from Fig. 21 that the increased density leads to the increased in-plane thermal conductivity.

### Example 7

Heat-conductive layers were produced in the same manner as in Example 3, except for changing the concentration of PMMA in the dispersion to 0.2% by mass, 0.5% by mass, and 1.0% by mass, respectively. Measurement revealed that each heat-conductive layer had thermal conductivity not different from that of Example 3. This indicates that the same mass ratio of carbon nanotube/(fine graphene particles + carbon nanotube) would provide the same thermal conductivity, even if the percentage of the binder resin were changed within the range of the present invention.

### EFFECTS OF THE INVENTION

The heat-dissipating film of the present invention comprising a heat-conductive layer containing fine graphene particles and carbon nanotube has high thermal conductivity and is resistant to fracture when bent. Because the method of the present invention produces a dense, heat-conductive layer by heat-pressing a mixture layer comprising fine graphene particles, carbon nanotube and a binder resin for densification, burning it, and then pressing the burnt layer, the resultant heat-conductive layer has not only high density and thermal conductivity, but also good bending rupture resistance, without unevenness in performance. Because the mixture layer is formed by coating a plastic film with a dispersion comprising fine graphene particles, carbon nanotube and a binder resin, the production cost of the heat-dissipating film can be low. The heat-dissipating film of the present invention having such feature is suitable for small electronic appliances such as note-type personal computers, smartphones, tablets, mobile phones, etc.

## Claims

1. A heat-dissipating film (1) comprising a heat-conductive layer (10) comprising
- fine graphene particles (31) and carbon nanotube (32) uniformly dispersed;
- a mass ratio of said carbon nanotube (32) to the total of said fine graphene particles (31) and said carbon nanotube (32) being 0.05 - 0.2;
- said fine graphene particles (31) being substantially aligned with said heat-conductive layer (10); and
- said heat-conductive layer (10) having a density of 1.9 g/cm³ or more and thermal conductivity of 600 W/mK or more.

2. The heat-dissipating film (1) according to claim 1, wherein said heat-conductive layer (10) has a thickness of 50 - 250 g/m² (expressed by the total weight of fine graphene particles and carbon nanotube per 1 m²).

3. The heat-dissipating film (1) according to claim 1 or 2, wherein said heat-conductive layer (10) is covered with plastic films (2, 2).

4. A method for producing a heat-dissipating film (1) comprising a heat-conductive layer (10) comprising
- fine graphene particles (31) and carbon nanotube (32) uniformly dispersed,
- a mass ratio of said carbon nanotube (32) to the total of said fine graphene particles (31) and said carbon nanotube (32) being 0.05 - 0.2, and
- said fine graphene particles (31) being substantially aligned with said heat-conductive layer (10),
comprising the steps of
(1) sandwiching a mixture layer (11) comprising said fine graphene particles (31) and said carbon nanotube (32) at said mass ratio, and further comprising a binder resin at a mass ratio of 0.01 - 0.1 per the total amount of said fine graphene particles (31) and said carbon nanotube (32), with a pair of first plastic films (12a, 12b), to form a laminated film (1');
(2) heat-pressing said laminated film (1') to densify said mixture layer (11);
(3) burning said mixture layer (11) exposed by peeling said first plastic films (12a, 12b);
(4) pressing the burnt layer (131) to provide a densified heat-conductive layer (10); and
(5) covering said densified heat-conductive layer (10) with second plastic films (13a, 13b) or an insulating resin.

5. The method for producing a heat-dissipating film (1) according to claim 4, wherein a step of applying a dispersion comprising 5 - 25% by mass in total of fine graphene particles (31) and carbon nanotube (32), and 0.05 - 2.5% by mass of a binder resin in an organic solvent, a mass ratio of the binder resin/(fine graphene particles + carbon nanotube) being 0.01 - 0.1, to a surface of each first plastic film, and drying it, is repeated plural times, to form said mixture layer (11).

6. The method for producing a heat-dissipating film (1) according to claim 4 or 5, wherein the amount of said dispersion applied by one operation is 5 - 30 g/m² (expressed by the total weight of fine graphene particles and carbon nanotube per 1 m²).

7. The method for producing a heat-dissipating film (1) according to any one of claims 4 to 6, wherein said first plastic film has a parting layer on a surface to be coated with said dispersion.

8. The method for producing a heat-dissipating film (1) according to any one of claims 4 to 7, wherein said laminated film passes through at least a pair of heating rolls to heat-press said laminated film (1').

## Patentansprüche

1. Wärme ableitende Folie (1), umfassend eine wärmeleitfähige Schicht (10), umfassend
- feine Graphen-Teilchen (31) und Kohlenstoff-Nanoröhrchen (32) einheitlich darin dispergiert; wobei
ein Massenverhältnis von Kohlenstoff-Nanoröhrchen (32) zu der Gesamtmenge feiner Graphen-Teilchen (31) und Kohlenstoff-Nanoröhrchen (32) 0,05 bis 0,2 ist;
die feinen Graphen-Teilchen (31) im Wesentlichen mit der wärmeleitfähigen Schicht (10) ausgerichtet sind; und
die wärmeleitfähige Schicht (10) eine Dichte von 1,9 g/cm³ oder mehr und eine thermische Leitfähigkeit von 600 W/mK oder mehr aufweist.

2. Wärme ableitende Folie (1) nach Anspruch 1, worin die wärmeleitfähige Schicht (10) eine Dicke von 50 bis 250 g/m² (ausgedrückt durch das Gesamtgewicht der feinen Graphen-Teilchen und der Kohlenstoff-Nanoröhrchen pro 1 m²) aufweist.

3. Wärme ableitende Folie (1) nach Anspruch 1 oder 2, worin die wärmeleitfähige Schicht (10) mit Kunststoff-Filmen (2, 2) bedeckt ist.

4. Verfahren zur Herstellung einer Wärme ableitenden Folie (1), umfassend eine wärmeleitfähige Schicht (10), umfassend
- feine Graphen-Teilchen (31) und Kohlenstoff-Nanoröhrchen (32) einheitlich darin dispergiert; wobei
ein Massenverhältnis von Kohlenstoff-Nanoröhrchen (32) zu der Gesamtmenge feiner Graphen-Teilchen (31) und Kohlenstoff-Nanoröhrchen (32) 0,05 bis 0,2 ist; und
die feinen Graphen-Teilchen (31) im Wesentlichen mit der wärmeleitfähigen Schicht (10) ausgerichtet sind;
welches die Schritte umfaßt, daß man
(1) eine Mischungs-Schicht (11), die feine Graphen-Teilchen (31) und Kohlenstoff-Nanoröhrchen (32) in dem Massenverhältnis umfaßt, und darüber hinaus ein Binderharz in einem Massenverhältnis von 0,01 - 0,1 pro Gesamtmenge der feinen Graphen-Teilchen (31) und der Kohlenstoff-Nanoröhrchen (32) umfaßt, zwischen ein Paar erster Kunststoff-Filme (12a, 12b) sandwichartig einlegt, um einen laminierten Film (1') zu bilden;
(2) den laminierten Film (1') heißpresst, um die Mischungs-Schicht (11) zu verdichten;
(3) die Mischungsschicht (11), die durch Abziehen der ersten Kunststoff-Filme (12a, 12b) freigelegt wurde, einem Brennen aussetzt;
(4) die gebrannte Schicht (131) presst, um eine verdichtete wärmeleitfähige Schicht (10) bereitzustellen; und
(5) die verdichtete wärmeleitfähige Schicht (10) mit zweiten Kunststoff-Filmen (13a, 13b) oder einem isolierenden Harz bedeckt.

5. Verfahren zur Herstellung eines Hitze ableitenden Films (1) nach Anspruch 4, worin ein Schritt des Aufbringens einer Dispersion, die umfaßt 5 - 25 Massen-% pro Gesamtmenge feiner Graphen-Teilchen (31) und Kohlenstoff-Nanoröhrchen (32), und 0,05 - 2,5 Massen-% eines Binderharzes in einem organischen Lösungsmittel, wobei ein Massenverhältnis von Binderharz/(feine Graphen-Teilchen + Kohlenstoff-Nanoröhrchen) 0,01 - 0,1 ist, auf eine Oberfläche eines jeden ersten Kunststoff-Films und diesen trocknet, mehrere Male wiederholt wird, um die Mischungsschicht (11) zu bilden.

6. Verfahren zur Herstellung eines Hitze ableitenden Films (1) nach Anspruch 4 oder 5, worin die Menge der Dispersion, die pro Vorgang aufgebracht wird, 5 - 30 g/m² (ausgedrückt durch das Gesamtgewicht feiner Graphen-Teilchen und Kohlenstoff-Nanoröhrchen pro 1 m²) ist.

7. Verfahren zur Herstellung eines Hitze ableitenden Films (1) nach irgendeinem der Ansprüche 4 bis 6, worin der erste Kunststoff-Film eine Trennschicht auf der mit der Dispersion zu beschichtenden Oberfläche aufweist.

8. Verfahren zur Herstellung eines Hitze ableitenden Films (1) nach irgendeinem der Ansprüche 4 bis 7, worin der laminierte Film durch wenigstens ein Paar Wärmewalzen durchgeführt wird, um den laminierten Film (1') heißzupressen.

## Revendications

1. Film de dissipation de chaleur (1) comprenant une couche conductrice de chaleur (10) comprenant
- des particules fines de graphène (31) et un nanotube de carbone (32) dispersés uniformément ;
- un rapport massique dudit nanotube de carbone (32) au total desdites particules fines de graphène (31) et dudit nanotube de carbone (32) allant de 0,05 à 0,2 ;
- lesdites particules fines de graphène (31) étant substantiellement alignées avec ladite couche conductrice de chaleur (10) ; et
- ladite couche conductrice de chaleur (10) ayant une densité volumique de 1,9 g/cm³ ou plus et une conductivité thermique de 600 W/mK ou plus.

2. Film de dissipation de chaleur (1) selon la revendication 1, dans lequel ladite couche conductrice de chaleur (10) a une épaisseur de 50 à 250 g/m² (exprimée par le poids total de particules fines de graphène et de nanotube de carbone pour 1 m²).

3. Film de dissipation de chaleur (1) selon la revendication 1 ou la revendication 2, dans lequel ladite couche conductrice de chaleur (10) est recouverte de films en matière plastique (2, 2).

4. Méthode de production d'un film de dissipation de chaleur (1) comprenant une couche conductrice de chaleur (10) comprenant
- des particules fines de graphène (31) et un nanotube de carbone (32) dispersés uniformément ;
- un rapport massique dudit nanotube de carbone (32) au total desdites particules fines de graphène (31) et dudit nanotube de carbone (32) allant de 0,05 à 0,2, et
- lesdites particules fines de graphène (31) étant substantiellement alignées avec ladite couche conductrice de chaleur (10),
comprenant les étapes consistant à
(1) prendre en sandwich une couche de mélange (11) comprenant lesdites particules fines de graphène (31) et ledit nanotube de carbone (32) audit rapport massique, et comprenant en outre une résine liante à un rapport massique de 0,01 à 0,1 pour la quantité totale desdites particules fines de graphène (31) et dudit nanotube de carbone (32), avec une paire de premiers films en matière plastique (12a, 12b), afin de former un film stratifié (1') ;
(2) presser à chaud ledit film stratifié (1') afin de densifier ladite couche de mélange (11) ;
(3) faire brûler ladite couche de mélange (11) exposée en pelant lesdits premiers films en matière plastique (12a, 12b) ;
(4) presser la couche brûlée (131) afin de fournir une couche conductrice de chaleur densifiée (10) ; et
(5) recouvrir ladite couche conductrice de chaleur densifiée (10) desdits deuxièmes films en matière plastique (13a, 13b) ou d'une résine isolante.

5. Méthode de production d'un film de dissipation de chaleur (1) selon la revendication 4, dans laquelle une étape consistant à appliquer une dispersion comprenant de 5 à 25 % en masse au total de particules fines de graphène (31) et de nanotube de carbone (32), et de 0,05 à 2,5 % en masse d'une résine liante dans un solvant organique, un rapport massique de la résine liante/(particules fines de graphène + nanotube de carbone) allant de 0,01 à 0,1, sur une surface de chaque premier film en matière plastique, et à la sécher, est répétée plusieurs fois, afin de former ladite couche de mélange (11).

6. Méthode de production d'un film de dissipation de chaleur (1) selon la revendication 4 ou la revendication 5, dans laquelle la quantité de ladite dispersion appliquée pour une utilisation va de 5 à 30 g/m² (exprimée par le poids total de particules fines de graphène et de nanotube de carbone pour 1 m²).

7. Méthode de production d'un film de dissipation de chaleur (1) selon l'une quelconque des revendications 4 à 6, dans laquelle ledit premier film en matière plastique a une couche de séparation sur une surface devant être revêtue de ladite dispersion.

8. Méthode de production d'un film de dissipation de chaleur (1) selon l'une quelconque des revendications 4 à 7, dans laquelle ledit film stratifié traverse au moins une paire de rouleaux chauffants afin de presser à chaud ledit film stratifié (1').
